Europäisches Patentamt

European Patent Office

Office européen des brevets

(11) Publication number: **0 477 957 A1**

## EUROPEAN PATENT APPLICATION

(21) Application number: **91116479.6**

(22) Date of filing: **26.09.91**

(51) Int. Cl.⁵: **H01L 21/027, G03F 7/20**

(30) Priority: **28.09.90 JP 259264/90**

(43) Date of publication of application:
**01.04.92 Bulletin 92/14**

(84) Designated Contracting States:
**DE FR GB**

(71) Applicant: **NEC CORPORATION**
**7-1, Shiba 5-chome Minato-ku**
**Tokyo 108-01(JP)**

(72) Inventor: **Yasuzato, Tadao, c/o NEC**
**Corporation**
**7-1, Shiba 5-chome**
**Minato-ku, Tokyo(JP)**
Inventor: **Saeki, Takanori, c/o NEC**
**Corporation**
**7-1, Shiba 5-chome**
**Minato-ku, Tokyo(JP)**

(74) Representative: **Glawe, Delfs, Moll & Partner**
**Patentanwälte**
**Postfach 26 01 62 Liebherrstrasse 20**
**W-8000 München 26(DE)**

(54) Process of fabricating semiconductor IC devices, including several lithographic steps and check patterns.

(57) A process of fabricating semiconductor integrated circuit devices according to the present invention comprises forming line and space (L/S) patterns on photoresists at different levels on a semiconductor chip where functional regions or interconnect patterns are formed, at the chip edge portions and in proximity to each other, by photolithography in conjunction with formation of conductor interconnect layer and interlayer film, etc.

In virtue of the present invention, it is possible to easily do previous check whether the whole surface of a semiconductor chip is within the depth of focus for exposure by examining the L/S patterns formed at a plurality of positions at different levels over the semiconductor chip under observation of them in one and the same visual field with an optical microscope, which thus makes it unnecessary to adjust on each occasion the depth of focus.

FIG.3

## BACKGROUND OF THE INVENTION

### Field of the Invention

This invention relates to a process of fabricating semiconductor integrated circuit (IC) devices, and more particularly to a process of fabricating such IC devices with a multilayer interconnection structure.

### Description of the Prior Art

With increasing density of semiconductor elements formed in a semiconductor, it has become required for the circuit interconnections formed between insulating films over the surface of the substrate to have a high pattern resolution of below 1 $\mu$ in linewidth, thus the correspondingly high level integration. Both for dense formation of elements in semiconductor substrate and for high pattern resolution of circuit interconnection and high level integration, the real image on a photoresist film from the associated mask must be ensured to have a required resolution. For this purpose, short wavelength-range light sources such as excimer laser have become used as a light source for use in exposing a photoresist film with a reduction-and-projection exposure system, stepper. As well known, the pattern resolution becomes higher in nearly direct proportion with shortening wavelength of the light source of the stepper, and is inversely proportional to the numerical aperture (NA) of the lens of the stepper (that is, becomes higher as the numerical aperture is larger). Since the method for making the resolution higher by using a light source of a wavelength as short as possible has reached a limitation as a practical problem, the use of a numerical aperture as great as possible has been being tried so far. On the other hand, the depth of focus (DOF) of the optical system of this stepper is inversely proportional to the square of the numerical aperture, and therefore higher resolution associated with larger numerical aperture inevitably results in smaller DOF, and in turn in narrower permissible range of optimum focus in the exposure process.

In lithography process for forming an impurity diffusion layer in a semiconductor substrate, a photoresist film formed for this is usually substantially in a plane, and hence exposure of it is free of problems encountered in narrow permissible range of optimum focus as above-mentioned. On the other hand, in process for forming an interconnect layer through the intermediation of an insulating film over the surface of a substrate or especially each layer for multilayer interconnection structure associated with high level integration, a photoresist film for this is formed as a stepper layer, which makes it difficult for the whole of the photoresist film to be within the above-mentioned permissible range. Exposure of the photoresist film, if at least a part of it is out of the permissible range, can be performed with the result of a defective circuit pattern which tends toward occurrence of short circuit or disconnection in a concerned pattern circuit, leading to a reduced yield of reliable products.

On the other hand, the above-mentioned stepper is usually provided with an autofocus mechanism to be designed to thereby automatically determine the above-mentioned optimum focus. The precise measurement of a distance by this mechanism is based on the interference produced in combination with the reflected light from an IC surface. If the surface is stepped, the light interference is affected thereby, leading to poor measurement precision of distance. In lithography process of a stepped IC-surface, after exposure and development of the photoresist, the real circuit pattern either entirely or partially including stepped part is ensured by observation with a microscope, then going to the next processing step. An alternative similar procedure is used that instead of the read circuit pattern, a certain check pattern, usually a line and space (L/S) repeat pattern consisting of stripes and spaces arranged side by side alternately (See the Integrated Circuit Handbook p. 269, Fig. 6.109, 1968; Issued by Maruzen) is identified by microscope examination. The former procedure however becomes more difficult to be performed, with increasing complication of circuit patterns in practice. Accordingly there is generally a tendency to adopt the latter procedure.

The latter procedure however likewise can not remove the unwanted effect due to the stepped surface because the optimum focus of a check pattern formed directly on IC substrate, though it can be determined, can not be a deciding factor whether the level difference involving the interconnection pattern over the stepped surface is within the permissible range of optimum focus, or not.

## BRIEF SUMMARY OF THE INVENTION

It therefore is the principal object of the present invention to provide a process of fabricating high level integrated ICs of a stepped multilayer interconnection structure permitting to easily check whether or not the exposure and development of the photoresist film corresponding to each interconnection layer have been carried out to a desired resolution.

A high level integrated IC according to the present invention has a feature that such a check pattern as above-mentioned is provided at at least two levels, respectively, of the multilayer interconnection structure, for example, in the edge portion of the IC chip, and in the proximity to each other to make it for them to be at the same time observed microscopically. These check patterns at different levels of the multilayer interconnection structure are formed simultaneously with formation of, and together with, the real cicuit patterns of the respective levels, for example, in the edge portions of the chip. Moreover the check patterns are formed on interlayer insulating films when there is no limitation for location or arrangement of the real circuit patterns. On the other hand when there is substantial limitation for these patterns, the respective dummy interconnect layer in conjunction with the real circuit patterns, are made at levels of the multilayer interconnection structure, and check patterns are formed in the dummy interconnect layers in the proximity to each other.

According to the present invention, in the process of forming interconnection patterns at the layers over the surface of a high-level integrated IC chip having a multilayer-interconnection structure, whether or not the real image of interconnection pattern produced on a photoresist film from a mask is within in the permissible range of the aforesaid optimum focus can be checked at at least two layer levels on the IC chip by microscopic observation, and thereby the real image from the mask can be prevented from lowering in its resolution.

BRIEF DESCRIPTION OF THE DRAWINGS

The above-mentioned and other objects, features and advantage of this invention will become more apparent by reference to the following detailed description of the invention taken in conjunction with the accompanying drawings, wherein:

Figs. 1(a) through 1(d) are fragmentary plan views at processing steps for illustrating an process of fabricating and IC as an embodiment of the present invention;
Fig. 2 is a plan view schematically illustrating a part of Fig. 1(d) to an enlarged scale;
Fig 3 is a longitudinal sectional view along line X-X of Fig. 2; and
Fig. 4 is a longitudinal sectional view of an IC chip for illustrating an alternative embodiment of the present invention.

DETAILED DESCRIPTION OF THE PREFERRED EMBODIMENTS

Two embodiments of the present invention will be described with reference to the accompanying drawings hereinafter:

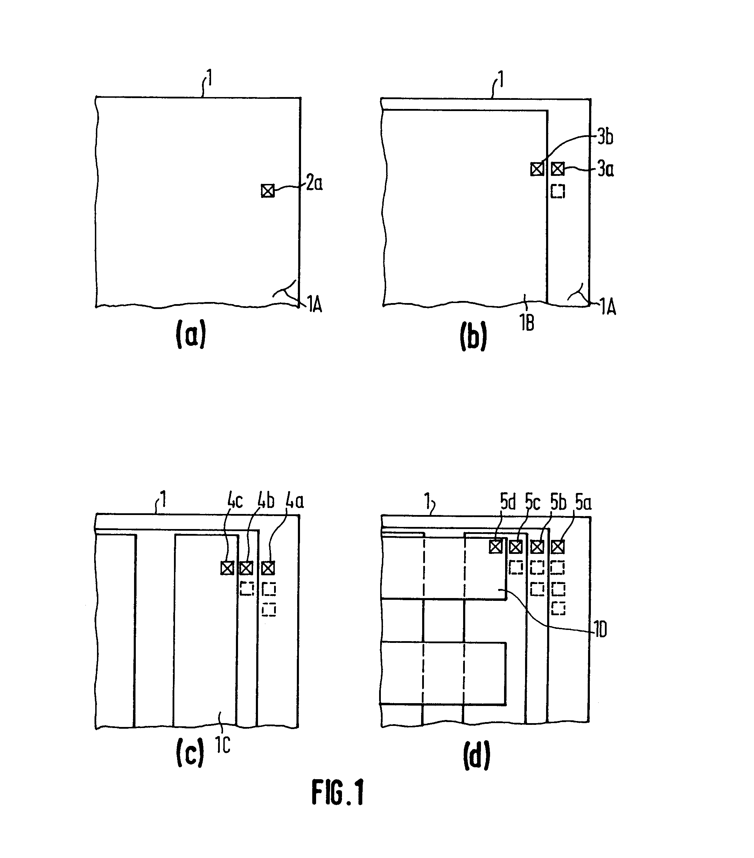

Referring to Figs. 1(a) through 1(d) for illustrating an embodiment of the present invention for fabricating a high-level integrated DRAM device, a photoresist is applied over the entire surface of a semiconductor substrate 1 of silicon (Si). The photoresist film is exposed through a mask with pattern corresponding to active regions, and the next processing step of forming anywhere on the substrate surface except the corresponding portions to the active regions into field oxide film is carried out. At the same time with this, the aforesaid L/S pattern 2a is formed at the edge portion 1A of the field oxide film as shown in Fig. 1(a), out of which the holes for the active regions are and thus not shown.

Over the whole surface of the field oxide film with holes (Fig. 1(a)), a photoresist film is formed, followed by a desired patterning, and then a gate insulating film is formed on the hole areas. Simultaneously with this, L/S patterns 3a and 3b are formed at the edge portions 1A and 1B of, thus at the same levels as, the field oxide film and the gate interconnect layer, respectively, as shown in Fig. 1(b). In conjunction with this, L/S pattern 2a previsously-formed at the field oxide film edge portion and indicated by a dotted line is etched away.

Then the first polysilicon interconnect layer connected to the drain region or source region (not shown) formed in each active area similarly is formed by coating of a photoresist film, and exposure and development for the interconnection pattern are formed, and at the same time L/S pattern 4a, 4b and 4c at the edge portions 1A to 1D in the same planes as the field oxide film, gate-interconnect layer and polysilicon interconnect layer, respectively, as shown in Fig. 1(c). Besides in this process, L/S patterns 3a, 3b (indicated by dotted lines in Fig. 1(c)) formed simultaneously with the gate-interconnect layer are etched away.

Subsequently an dielectric layer of interlayer insulating layer is formed and then the second polysilicon interconnect layer connected to each source or drain region (not shown) of the active areas is formed to construct a capacitor. In conjunction with this, L/S patterns 5a, 5b, 5c and 5d are formed, in the process of patterning a photoresist, at the edge portions 1A, 1B, 1C and 1D in the same planes as the field oxide film, gate interconnect layer, polysilicon interconnection layer, respectively (Fig. 1(d)). In this process, at the same time L/S patterns 4a, 4b and 4c indicated by dotted lines in Fig. 1(d) are removed. Those L/S patterns 2a, 3a, 3b, 4a to 4c and 5a to 5d are formed in the proximity to each other to permit them altogether to be observed within a microscopic visual field.

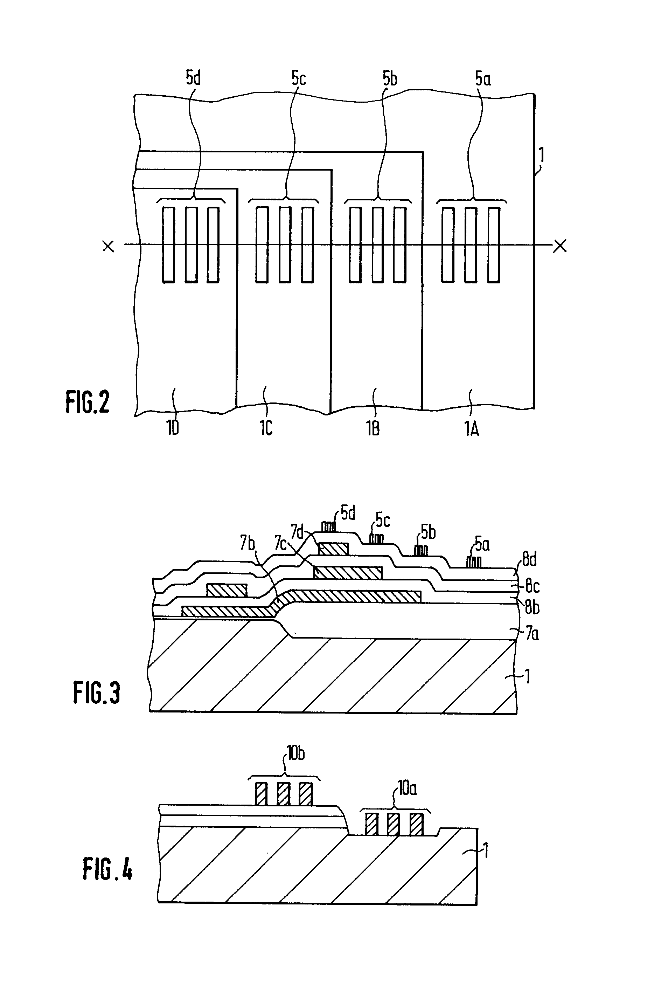

Fig. 2 diagrams schematically to an enlarged scale L/S pattern portions 5a, 5b, 5c and 5d of semiconductor chip 1 (in Fig. 1(d)) with formed in the above-described processes, and Fig. 3, a cross section of Fig. 2, the arrangement of L/S patterns 5a, 5b, 5c and 5d formed at the edges 1A, 1B, 1C and 1D of the field oxide film, gate interconnect layer, and the first and second polysilicon interconnection layers, respectively, at different levels from the surface of substrate 1.

In the above-described sequential processes, check whether or not the photoresist film for formation of gate interconnect film (Fig. 1(b)) is within the permissible range of optimum focus of the exposure system is carried out by simultaneous examination of the resolutions of L/S patterns 3a and 3b with a microscope. Likewise whether or not the field oxide film, gate interconnect film, the first polysilicon interconnect layer are formed within the above-mentioned permissible range is checked by microscopically examining the resolutions of L/S patterns 4a, 4b and 4c. Check whether or not the field oxide film 7a to the second polysilicon interconnect layer 7d are within the above-mentioned permissible range is carried out by microscopically observing L/S patterns 5a, 5b, 5c and 5d. As described above, in this embodiment, it can be easily checked at the stage of patterning the photoresist whether or not the interconnection pattern of the interconnect layer formed in an intended process is formed with a desired resolution. If a result of poor resolution is yielded, then the chip is reprocessed by recoating of photoresist, followed by exposure and development. In this way, yield of reliable products can be improved.

Referring to Fig. 4 illustrating Embodiment 2 of the present invention in similar cross section to Fig. 3, a L/S pattern 10a similar to that in Embodiment 1 is formed in a recess 9 (of practically about several $\mu$m in depth through shown with enhancement) previously made at the edge portion of chip 1, for example, by etching. The pattern 10a and another L/S pattern 10b on the interconnect layer are used as object for resolution check with a microscope. The respective respects are the same as in Embodiment 1, and further description is omitted. It would be obvious this construction can be applied to other types of IC devices as well as DRAM exemplified in Embodiment 1.

In Embodiments 1 and 2 described above are used L/S patterns each consisting of three stripes of 0.4 to 0.8 $\mu$m in width and space, respectively, and about 10 times the width in length. The microscopic magnification used for the checking was 40, and its suitable range is about 20 to about 100.

Although the invention has been described with reference to specific embodiments, this description is not meant to be construed in a limiting sense. Various modifications of the disclosed embodiments, as well as other embodiments of the invention, will become apparent to persons skilled in the art upon reference to the description of the invention. It is therefore contemplated that the appended claims will cover any modifications or embodiments as fall within the true scope of the invention.

## Claims

1. A process of fabricating a semiconductor integrated circuit device including a semiconductor substrate containing a number of impurity diffusion regions formed at a high density therein, and a plurality of conductor interconnect layers, each being connected to said diffusion regions, respectively, formed in a multilevel structure with insulating film placed between said layers over the surface of said semiconductor substrate, and having partial surfaces at a plurality of levels defined by at least either said insulating films or said interconnect Layers, said process comprising making a lithography photoresist film for forming said interconnect layer, at at least two partial surfaces, respectively, at substantially the same levels as previously-determined two of said plurality of levels, said partial surfaces never causing electrical connection with said conductor interconnect layers, and in proximity to each other; exposing said photoresist films through a mask with a line and space pattern and developing the real-image of said line and space pattern on said photoresist film; and examining the resolution of said real image with a microscope.

2. A process of manufacturing a semiconductor integrated circuit device according to claim 1, wherein said semiconductor integrated circuit device is a MOS dynamic RAM and said partial surfaces are formed simultaneously with formation of said plurality of conductor interconnect layers and insulating films.

3. A process of fabricating a semiconductor integrated circuit device according to claim 1 further comprising a processing step for etching said substrate previously to formation of said diffusion regions to form a recess defining at least one of said plurality of levels at the position responding to said surface portions of the said substrate.

FIG.1

FIG.2

FIG.3

FIG.4

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | EP-A-0 242 744   (NEC CORP.)<br>* column 1, lines 1 - 53 * * column 5, lines 1 - 10; claims 1, 3; figures 3, 5A * | 1,2 | H 01 L 21/027<br>G 03 F 7/20 |
| A | EP-A-0 342 881   (BRITISH TELECOMMUNICATIONS)<br>* column 1, lines 4 - 30 * * column 1, line 54 - column 2, line 15 * * column 2, lines 44 - 52; claims 1, 2; figure 1 * | 1,2 | |
| A | US-A-4 863 548   (WON-SIK LEE)<br>* column 1, line 14 - column 2, line 5 * | 1,2 | |
| A | US-A-4 904 569   (HIROSHI FUKUDA ET AL.)<br>* column 14, lines 21 - 63; claim 1; figures 7A-7C * | 1 | |
| A | MICROELECTRONIC ENGINEERING. vol. 9, no. 1-4, May 1989, AMSTERDAM NL pages 79 - 82; B. HUYNH et al.: "Calibrated exposure and focus test patterns for characterization of optical projection printing"<br>* page 79, paragraph 1; figures 1, 2 * * page 80, paragraph 3,4; figures 7-12 * | 1 | |
| P,A | IEEE TRANSACTIONS ON ELECTRON DEVICES. vol. 38, no. 1, January 1991, NEW YORK US pages 67 - 75; Hiroshi FUKUDA et al.: "New approach to resolution limit and advanced image formation techniques in optical lithography"<br>* pages 67 - 68, left-hand column; figure 1 * * page 69, paragraph B; figure 3 * | 1 | **TECHNICAL FIELDS SEARCHED (Int. Cl.5)**<br><br>G 03 F<br>H 01 L<br>G 03 B |
| A | EP-A-0 378 033   (ETAT FRANCAIS (CNET))<br>* column 1, line 33 - column 2, line 24 * | 1 | |

The present search report has been drawn up for all claims

| Place of search | Date of completion of search | Examiner |
|---|---|---|
| Berlin | 19 December 91 | KLOPFENSTEIN P R |